# EUROPEAN PATENT APPLICATION

(11) **EP 4 408 149 A1**
(43) Date of publication of application: **31.07.2024**
(21) Application number: 22872712.9
(22) Date of filing: 07.09.2022
(51) Int. Cl.: H10N 60/10, B82Y 10/00, G06N 10/00, H01L 29/06

(54) **ELECTRON-TRAPPING DEVICE, QUANTUM COMPUTER, METHOD FOR MANUFACTURING FLIP-CHIP STRUCTURE, AND ELECTRON-TRAPPING METHOD**

(30) Priority: 22.09.2021 US 202163246977 P; 28.12.2021 JP 2021214871
(71) Applicant: Japan Science and Technology Agency, Kawaguchi-shi, Saitama 332-0012 (JP)
(72) Inventor: NOGUCHI, Atsushi, Tokyo 153-8904 (JP); OSADA, Alto, Tokyo 153-8904 (JP); NAKAMURA, Yasunobu, Tokyo 153-8904 (JP)
(74) Representative: Noble, Nicholas
(86) International application number: PCT/JP2022/033534
(87) International publication number: WO 2023/047956

(57) **Abstract**

Electron trap device 1 comprises a cryogenic apparatus 40, a superconducting circuit 10 and a heat bath 60. The superconducting circuit 10 and the heat bath 60 are placed within the cryogenic apparatus 40. This allows the superconducting circuit 10 to operate and the heat bath 60 to be maintained at a constant low temperature, e.g., about 20 mK. The superconducting circuit 10 comprises a cooling resonator 20, a microwave resonator 22 and an electron trap region 50. The superconducting circuit 10 comprises a microstructure in which the opposing electrodes are arranged in a position that is linear symmetrical to the center line through the electron trap region and surrounded by a superconductor, such that the electron trap region 50 comprises a plurality of opposing electrodes.

## Description

### TECHNICAL FIELD

This disclosure relates to an electron trap device, a quantum computer, a flip-chip structure manufacturing method and an electron trap method.

This application claims priority based on U.S. Provisional Patent Application No. 63246977, filed September 22, 2021. The entire specification of the provisional application is incorporated herein by reference.

### BACKGROUND ART

Recently, microwave electron trapping has been proposed as a technique for trapping, i.e., capturing, electrons at room temperature, for example, Non-Patent Literature 1.

### Prior Art Literature

### Non-Patent Literature

Non-Patent Literature 1 : "Trapping Electrons in a Room-Temperature Microwave Paul Trap", Clemens Matthiesen, Qian Yu, Jinen Guo, Alberto M. Alonso, Alberto M. Alonso, and Alberto M. Alonso. Guo, Alberto M Alonso and Hartmut Haffner, Phys. Rev. X 11,011019, Published 29 January 2021

### SUMMARY OF INVENTION

### TECHNICAL PROBLEM

In order to trap electrons, it is necessary to apply high power and high frequency electromagnetic waves. Furthermore, electrons cannot be cooled using laser cooling. Therefore, the technology described in non-patent literature 1 cannot trap electrons which are cooled down to the ground state as isolated particles, levitating in space.

The purpose of this disclosure is to provide a technique for trapping electrons which are cooled down to the ground state as isolated particles, levitating in space.

### SOLUTION TO PROBLEM

In order to solve the above problems, an electron trap device of one embodiment of this disclosure comprises a superconducting circuit comprising a cooling resonator, a microwave resonator and an electron trap region, a cryogenic apparatus for operating the superconducting circuit and a heat bath for cooling the electrons. The superconducting circuit comprises a microstructure in which the opposing electrodes are arranged in a position that is linear symmetrical to the center line through the electron trap region and surrounded by a superconductor, such that the electron trap region comprises a plurality of opposing electrodes.

According to this embodiment, electrons which is cooled to the ground state can be trapped as isolated particles, levitating in space.

In one embodiment, the microstructure may have a length of 1 mm or less per side.

In one embodiment, the microstructure may be a flip-chip structure.

In one embodiment, the electron trap region may comprise at least two cooling electrodes and at least two microwave electrodes.

In one embodiment, the superconducting circuit may comprise a circuit comprising a Josephson element for raising the oscillation frequency of the electrons before bringing them into contact with the heat bath.

In one embodiment, the circuit comprising a Josephson element may be a cooling qubit element.

In one embodiment, the electron trap device may comprise a resonator that converts the vibrational state of the electrons into microwave photons of microwave frequency.

In one embodiment, the electron trap device may comprise a microwave photon reader that reads out the characteristics of the converted microwave photons.

In one embodiment, the electron trap device may comprise a qubit element for exciting a qubit based on the vibrational state of the electrons.

In one embodiment, the electron trap device may comprise a magnetic field gradient generator that generates a magnetic field gradient in the electron trap region.

In one embodiment, the electron trap device may comprise a spin reader that reads out information on the electron spin observed based on such a magnetic field gradient.

In one embodiment, the electron trap device may comprise a quantum entanglement generator that generates quantum entanglement based on the information of electron spins.

In one embodiment, the electron trap device may comprise a control unit that controls the cooling of the electrons, the excitation of the qubits and the read-out of the properties of the converted microwave photons.

Another embodiment of the disclosure is a quantum computer. This quantum computer comprises the aforementioned electron trap devices connected together.

Yet another embodiment of the disclosure is a method for manufacturing a flip-chip structure of the aforementioned electron trap device. The method includes supporting both ends of the lower chip and the upper chip by a metal that does not become superconducting even at low temperature and supporting the center part by a metal that becomes superconducting at low temperature, holding the upper chip from above in the state and heating to bond it to the lower chip and coating the metal that does not become superconducting with silver paste for thermal contact and fixation.

In one embodiment, the metal that does not become superconducting may be harder than the metal that becomes superconducting.

In one embodiment, the metal that does not become superconducting may be AgCu, Cu or Pt and the metal that becomes superconducting may be Pb or In.

Yet another embodiment of the disclosure is an electron trap method. The method includes trapping electrons in an electron trap region using a superconducting circuit comprising a cooling resonator, a microwave resonator and an electron trap region and cooling the trapped electrons using a heat bath. The superconducting circuit comprises a microstructure in which the opposing electrodes are arranged in a position that is linear symmetrical to the center line through the electron trap region and surrounded by a superconductor, such that the electron trap region comprises a plurality of opposing electrodes.

According to this embodiment, electrons which are cooled to the ground state can be trapped as isolated particles, levitating in space.

Yet another embodiment of the disclosure is an electron trap device that simultaneously traps electrons and ions and cools the electrons to their ground state through Coulomb interaction between the electrons and ions. This device comprises a trap circuit comprising an ion cooler, a microwave resonator and an RF resonator, an electron-ion trap region. The trap circuit comprises an upper chip and a lower chip. The upper chip and the lower chip comprise a DC electrodes, a microwave electrode for trapping electrons and an RF electrode for trapping ions. The microwave electrode and the RF electrode of the upper chip and the lower chip extend axially between the DC electrodes. The flip structure of the upper chip and the lower chip allows the DC electrode of the upper chip and the DC electrode of the lower chip to face each other, the microwave electrode of the upper chip and the RF electrode of the lower chip to face each other, the RF electrode of the upper chip and the microwave electrode of the lower chip to face each other.

According to this embodiment, electrons and ions are trapped simultaneously and the trapped ions are cooled by the ion cooler, which allows the electrons and ions to have Coulomb interaction with each other. Therefore, it is possible to cool the electrons to their ground state at room temperature.

Any combination of the above components, and conversion of the expressions of the present disclosure among methods, devices, systems, recording media, computer programs, etc., are also valid as an embodiment of the present disclosure.

### ADVANTAGEOUS EFFECTS OF INVENTION

According to the present disclosure, it is possible to trap electrons which are cooled down to the ground state as isolated particles, levitating in space.

### BRIEF DESCRIPTION OF DRAWINGS

[FIG. 1] Fig. 1 shows a schematic diagram of electrons trapped in an electron trap region on a superconducting circuit;
[FIG. 2] Fig. 2 shows a schematic diagram showing the principle of electron cooling using the superconducting circuit of Fig. 1;
[FIG. 3] Fig. 3 shows a schematic diagram showing a superconducting circuit with a cooling qubit element;
[FIG. 4] Fig. 4 shows a schematic diagram of a conventional superconducting circuit, in which the upper row schematically shows the configuration with an electron trap region on a planar chip, and the middle row and the bottom row are the distribution diagram and graph of the effective potential near the electron trap region formed by this configuration, respectively;
[FIG. 5] Fig. 5 shows a schematic diagram of the configuration of a superconducting circuit, in which the upper row schematically shows a superconducting circuit with a flip-chip structure, and the middle row and the bottom row are the distribution diagram and graph of the effective potential near the electron trap region formed by this configuration, respectively;
[FIG. 6] Fig. 6 shows a functional block diagram of the electron trap device according to the first embodiment;
[FIG. 7] Fig. 7 is a photograph of the superconducting circuit of the electron trap device of Fig. 1;
[FIG. 8] Fig. 8 shows a schematic diagram showing flip-chip mounting by inverting upper chip and overlapping it on top of the lower chip;
[FIG. 9] Fig. 9 shows a cross-sectional view in the y-z plane including the electron trap region of the superconducting circuit of the flip-chip structure;
[FIG. 10] Fig. 10 shows a functional block diagram of the electron trap device according to the second embodiment;
[FIG. 11] Fig. 11 shows a schematic diagram showing the principle of the electron trap device according to the third embodiment;
[FIG. 12] Fig. 12 shows a schematic diagram showing the principle of the electron trap device according to the fourth embodiment;
[FIG. 13] Fig. 13 shows a schematic diagram showing the principle of the electron trap device according to the fifth embodiment;
[FIG. 14] Fig. 14 shows a schematic diagram showing another example of the electron trap device according to the fifth embodiment;
[FIG. 15] Fig. 15 shows a schematic diagram showing a quantum computer according to the sixth embodiment;
[FIG. 16] Fig. 16 shows a schematic diagram showing a system, in which electrons trapped by an electron trap device and ions trapped by an ion trap device are coupled by Coulomb interaction;
[FIG. 17] Fig. 17 shows a top view schematically showing the upper chip for realizing the electron-ion simultaneous trap chip according to the seventh embodiment;
[FIG. 18] Fig. 18 shows a top view schematically showing the lower chip for realizing the electron-ion simultaneous trap chip according to the seventh embodiment;
[FIG. 19] Fig. 19 shows a cross-sectional view of the flip-chip mounting of the upper chip and the lower chip in the A-A' cross section of Fig. 17 and Fig. 18;
[FIG. 20] Fig. 20 shows the trap cross-section potential for electrons formed when the upper chip and the lower chip are flip-chip mounted;
[FIG. 21] Fig. 21 shows the trap cross-section potentials for beryllium ions formed when the upper chip and the lower chip are flip-chip mounted;
[FIG. 22] Fig. 22 shows the axial potential distribution of electrons and beryllium ions formed by flip-chip mounting the upper chip and the lower chip;
[FIG. 23] Fig. 23 shows the functional block diagram of the electron trap device according to the seventh embodiment;
[FIG. 24] Fig. 24 shows a photograph showing the alignment method for flip-chip mounting of the lower chip and the upper chip of Fig. 8;
[FIG. 25] Fig. 25 shows a schematic diagram and photograph showing the inclination of the upper chip when the upper chip is placed on top of the lower chip without doing anything;
[FIG. 26] Fig. 26 shows a graph showing the simulation results of the spatial distribution of the effective potential when the inclination of the upper chip is 0 degrees and 2.45 degrees, respectively;
[FIG. 27] Fig. 27 shows schematic diagram and photographs showing flip-chip mounting created by the method according to the eighth embodiment;
[FIG. 28] Fig. 28 shows a photograph and table showing the difference, i.e., height, width, and length, from the origin at the four points P1, P2, P3 and P4 on the chip in Fig. 27; and
[FIG. 29] Fig. 29 shows a flowchart showing the processing of the electron trap method according to the ninth embodiment.

### DESCRIPTION OF EMBODIMENTS

The disclosure will be explained below with reference to drawings based on suitable embodiments. The embodiments are examples rather than limitations of the disclosure. All features or combinations of features described in the embodiments are not necessarily essential to the disclosure. Identical or equivalent components, parts, and processes shown in each drawing shall be given the same symbol and duplicate explanations will be omitted where appropriate. The scale and shape of each part shown in each drawing are set for convenience in order to facilitate explanation and should not be construed as limiting unless otherwise noted. When terms such as "first", "second", etc. are used in this specification or in the claims, unless otherwise mentioned, such terms do not indicate any order or degree of importance, but only to distinguish one configuration from another. In addition, in each drawing, some parts of the components that are not important in explaining the embodiments are omitted.

Basic findings are explained before describing the specific embodiments. There are several methods for realizing qubits in quantum computers, including those that use superconducting qubits and those that use ion traps. Among these methods, ion traps preserve the quantum state of ions for a long time by levitating ionized atoms and separating them from external matter. Currently popular ion traps include the Penning trap, which combines an electrostatic field with a static magnetic field, and the Paul trap, which combines an RF electric field with an electrostatic field. In an ion trap, the ionized atoms can be cooled and trapped using laser cooling because the atoms interact strongly with light. Thus, ion traps have established methods for cooling ionized atoms to a quantum ground state in which only quantum fluctuations remain.

To realize a quantum computer with fewer errors, it is necessary to prevent diffusion of information in the quantum chip, i.e., to prevent decoherence. For this purpose, it is desirable to be able to trap electrons in the ground state as isolated particles, levitating in space. However, electrons have a lower mass than ions and have the property of oscillating at high frequencies, for example, 600MHz or higher, or microwave frequencies. To trap such electrons, it is necessary to apply electromagnetic waves of high power and high frequency. For example, electrons require high-power microwaves of, for example, 5W RF waves can be used for ions which have a larger mass than electrons. Furthermore, unlike ions, electrons cannot be laser-cooled, therefore they must be placed in contact with a cryogenic, for example, 20mK, heat bath, i.e., placed in a cryogenic environment, to cool them. In this case, there is a limit to the intensity of the electromagnetic waves that can be applied since the temperature of the cryogenic environment rises even with slight heating. Thus, in order to cool electrons to the ground state required for a quantum computer and trap them, the output power of electromagnetic waves, for example, microwaves, applied to electrons in a cryogenic environment must be kept low. However, an adequate method for realizing quantum bits by electron trapping has not been found to date.

The inventors have made the following findings as a result of their diligent research into the above-mentioned issues. First, electrons are trapped in an electron trap region formed on the superconducting circuit. It was found that the trapped electrons can be cooled by electrical contact with the heat bath. Namely, the trapped and levitated electrons do not directly contact the heat bath, instead, the oscillation of the electrons is converted into an oscillating current in the circuit through electrical interaction. The oscillating current then contacts the heat bath through a resistance. In this way, the trapped electrons can be cooled. This idea is completely original and the first of its kind in the world by the inventors. Here, the electron trap region is inside a well-shaped electrostatic potential.

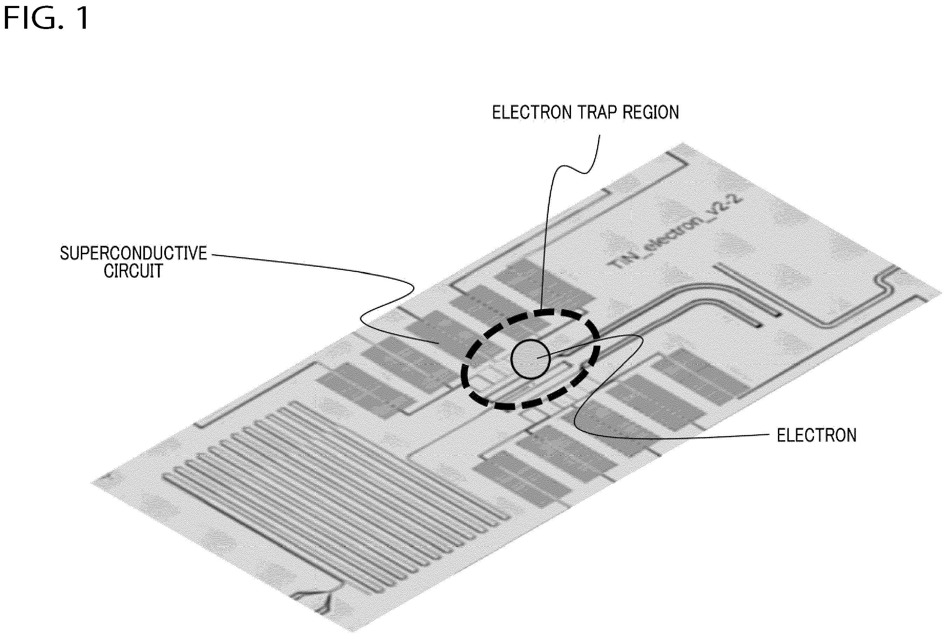

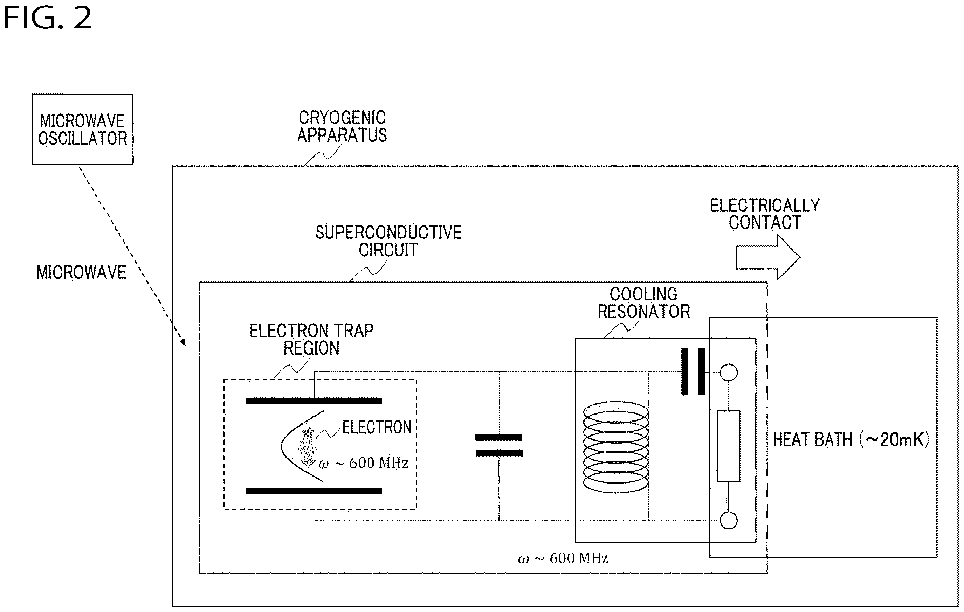

Figure 1 shows schematically how electrons are trapped in the electron trap region on the superconducting circuit. Figure 2 shows a schematic diagram of the principle of electron cooling using the above superconducting circuit. As illustrated, in this system, the superconducting circuit and the heat bath are placed in a cryogenic apparatus. The superconducting circuit includes an electron trap region and a cooling resonator. A well-shaped electrostatic potential is formed in the electron trap region. The electrons to be trapped oscillate at a frequency of about ω~600MHz in this environment. The heat bath is kept at a low temperature, for example, about 20mK. When microwaves of about 10pW are applied to the electron trap region, for example, these microwaves are amplified in the superconducting circuit. The cooling resonator can read the oscillations of the electrons as an electrical signal. The electrons can be cooled by electrical contact with a heat bath through this electrical signal.

The inventors next made the following findings. In the system in Figure 2, the trapped electrons are cooled by electrical contact with the heat bath while oscillating at ω~600MHz, namely are "discarding heat". In this case, there is a problem that heat flows into the electrons from the heat bath, as opposed to discarding heat. This is because, in light of the principle of blackbody radiation, the 20mK heat bath is "not a vacuum" for electrons oscillating at 600MHz, namely there is radiation that resonates with the 600MHz frequency in the 20mK blackbody. In other words, in order for heat not to flow in from the 20mK heat bath, i.e., for the heat bath to be a vacuum from the electrons' point of view, the electron frequency must be increased more.

To address this issue, the inventors realized that it would be effective to provide a circuit comprising Josephson elements within the superconducting circuit. That is, Josephson elements have nonlinearity and can add or subtract different frequencies. This allows the current frequency to be converted by externally applying microwaves corresponding to the difference between the target frequency, for example, 3GHz as described below, and the current frequency, for example, 600MHz. It should be noted that the frequency of the microwaves applied is not necessarily 2.4GHz but may be multiple microwaves corresponding to the difference. For example, the microwave frequency may be 2GHz +0.4GHz, 1.5GHz+0.5GHz+0.4GHz or 5GHz+2.6GHz. In the last example, however, 2.6GHz is used as a subtraction. By adding or subtracting frequencies in this way, 2.4GHz corresponding to the difference frequency is created, and the current frequency of 600MHz can be converted to the target frequency of 3GHz. However, what frequency should actually be irradiated depends on the circuit configuration.

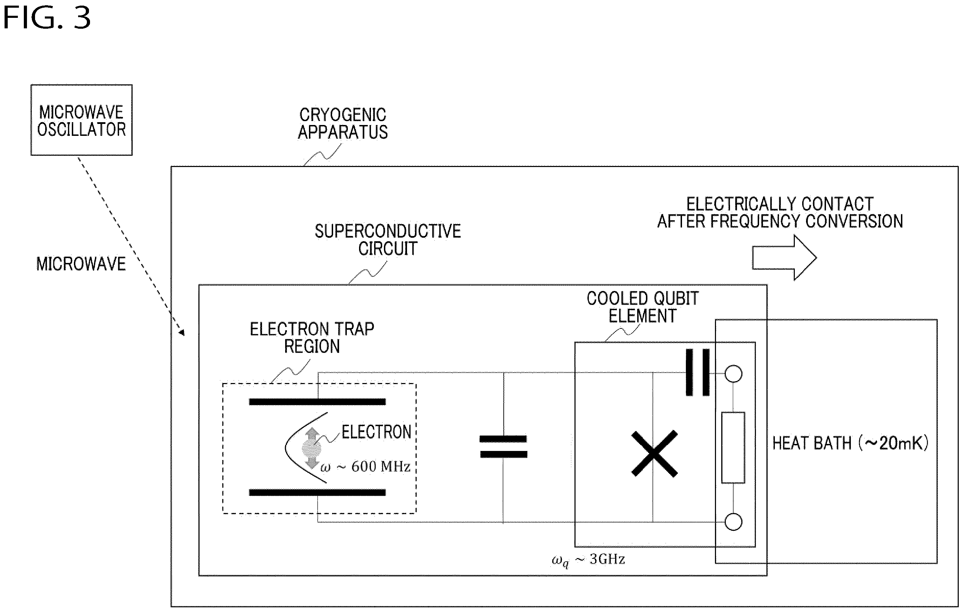

Figure 3 schematically shows a superconducting circuit comprising a cooling qubit element as an example of a circuit comprising Josephson elements. This cooling qubit element is generated using a Josephson junction, which raises the oscillation frequency of the electrons ω~600MHz to ω_{q}=3GHz.

Here, we will explain the relationship between ω and ω_{q}. According to the above principle of blackbody radiation, a 20mK heat bath can be regarded as substantially a vacuum for a frequency of 3GHz. In other words, by raising the oscillation frequency of electrons to 3GHz, heat can be prevented from flowing into the electrons from the heat bath. In other words, the trapped electrons make electrical contact with the heat bath after their oscillation frequency has been converted using a cooling qubit element, in other words, after the frequency has been raised to a frequency high enough that the heat bath can be regarded as substantially a vacuum. This greatly improves the cooling effect.

A circuit comprising Josephson elements may be a qubit.

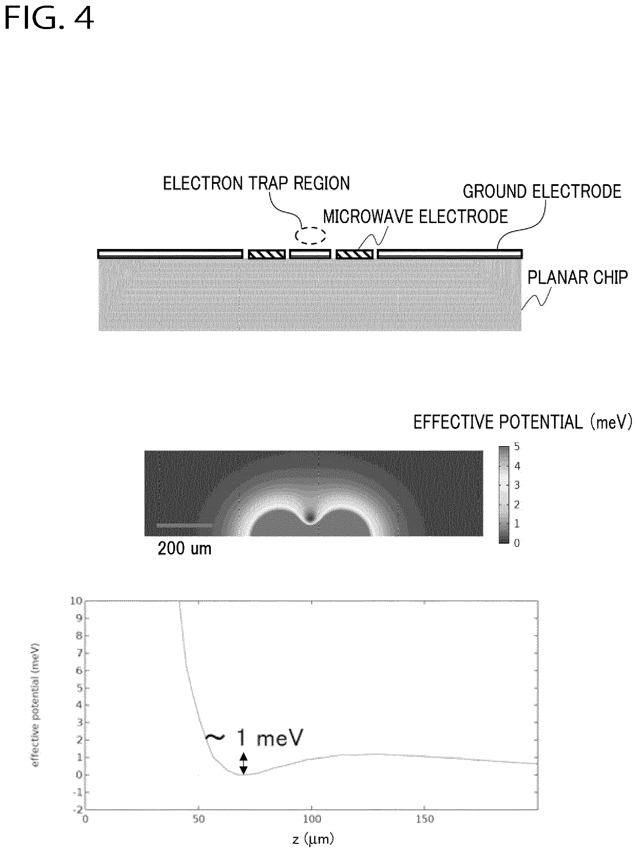

Furthermore, the inventors have made the following findings. First, we will explain the conventional technology using Figure 4. Figure 4 shows a type of superconducting circuit that traps electrons on a planar chip, conventional technology. The upper part of Figure 4 is a schematic diagram of a configuration in which two microwave electrodes are placed on a superconducting circuit of a planar chip type and the electron trap region is located between these electrodes. In other words, in this case, electron trap is performed by surface trapping. The middle row and the bottom row of Figure 4 show the effective potential near the electron trap region formed by this configuration. As illustrated, a well-shaped electrostatic potential is formed near the electron trap region. In this case, however, the well depth of the electrostatic potential is about 1meV. Sometimes such an effective potential is not sufficient to trap electrons. In this case, the depth of the well of electrostatic potential needs to be made effectively deeper.

To solve this problem, the inventors have found that it is effective if the superconducting circuit comprises a microstructure in which the opposing electrodes are arranged in a position that is linear symmetrical to the center line through the electron trap region and surrounded by a superconductor, such that the electron trap region comprises a plurality of opposing electrodes.

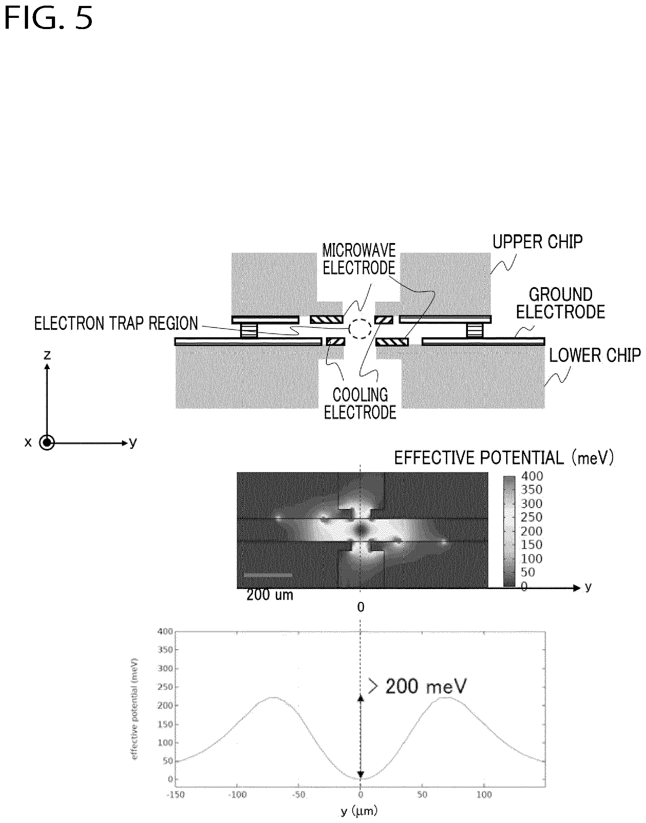

Figure 5 is used to illustrate the superconducting circuit of the structure. The upper part of Figure 5 schematically shows a superconducting circuit with a flip-chip structure. This superconducting circuit comprises an upper chip and a lower chip. The upper chip and the lower chip each have one microwave electrode and one cooling electrode. By using such a flip-chip structure, the superconducting circuit comprises a microstructure in which the opposing electrodes are arranged in a position that is lineally symmetrical to the center line through the electron trap region and surrounded by the superconductor. A well-shaped electrostatic potential is formed in the electron trap region surrounded by these four electrodes.

The middle row and the bottom row of Figure 5 show the effective potential near the electron trap region formed by this configuration. As illustrated, a well-shaped electrostatic potential is formed near the electron trap region. The well depth of this electrostatic potential exceeds 200meV. This effective potential is 200 times greater than that for surface trapping and is sufficient to trap electrons. Thus, by making the superconducting circuit a flip-chip structure such that the electron trap region comprises a plurality of opposing electrodes, a sufficient electrostatic potential to trap electrons can be obtained.

The microstructure surrounded by the aforementioned superconductor may have a length of 1 mm or less per side.

The microstructure surrounded by the aforementioned superconductor may be a flip-chip structure.

Regarding the size of the above electrodes, the size in the y-axis direction should be about 100um when the x-axis, y-axis and z-axis are taken as shown in Figure 5. Thus, the deepest electrostatic potential can be obtained by setting the size of the electrode in the y-axis direction to about 100um. On the other hand, there is no optimum value for the size of the electrode in the x-axis direction as in the y-axis direction, but it should be noted that it must be sufficiently shorter than the wavelength of the trapped microwaves, several cm, for example.

### The first embodiment

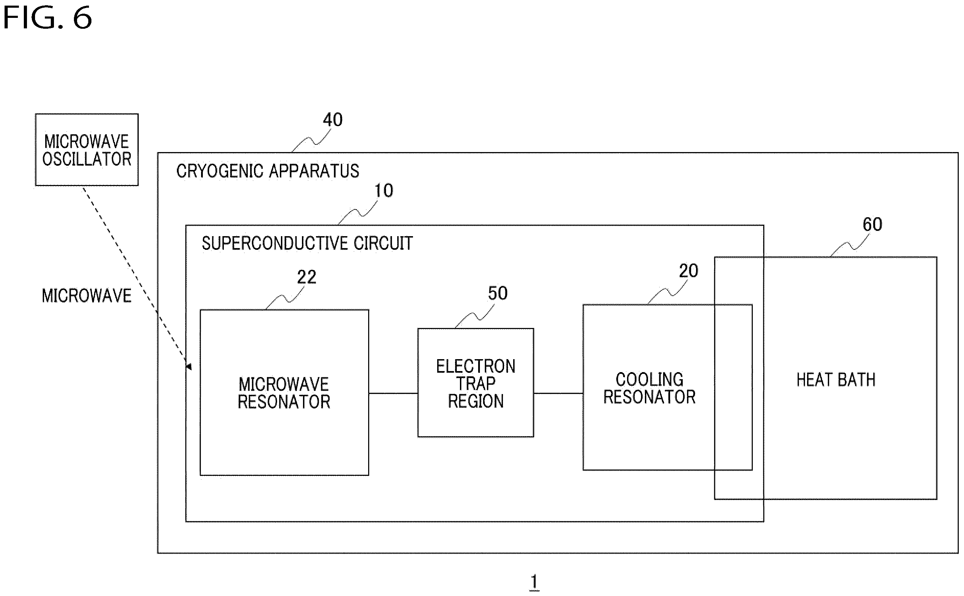

Figure 6 shows a functional block diagram of the electron trap device 1 according to the first embodiment. The electron trap device 1 comprises a cryogenic apparatus 40, a superconducting circuit 10 and a heat bath 60. The superconducting circuit 10 and the heat bath 60 are placed in the cryogenic apparatus 40. This allows the superconducting circuit 10 to operate at a low temperature. The heat bath 60 is maintained at a constant low temperature, for example, about 20mK. The superconducting circuit 10 comprises a cooling resonator 20, a microwave resonator 22 and an electron trap region 50. The superconducting circuit 10 comprises a flip-chip structure such that the electron trap region 50 comprises a plurality of opposing electrodes.

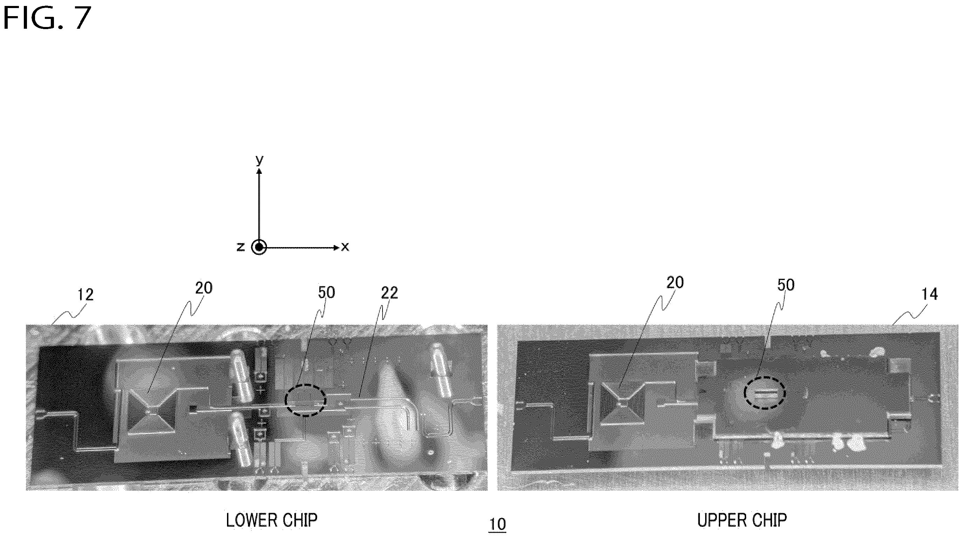

Figure 7 is a photograph of the superconducting circuit 10 of the electron trap device 1. Here, the x-axis is taken in the longitudinal direction of the superconducting circuit 10, the y-axis in the shortitudinal direction and the z-axis in the height direction from the back of the paper to the front. The photograph on the left shows the lower chip 12 of the superconducting circuit 10 and the photograph on the right shows the upper chip 14 of the superconducting circuit 10. The lower chip 12 comprises a cooling resonator 20, a microwave resonator 22 and an electron trap region 50. The upper chip 14 comprises a cooling resonator 20 and an electron trap region 50. The superconducting circuit 10 is formed by inverting the upper chip 14, overlapping it on the lower chip 12 and flip-chip mounting it in a sandwich configuration.

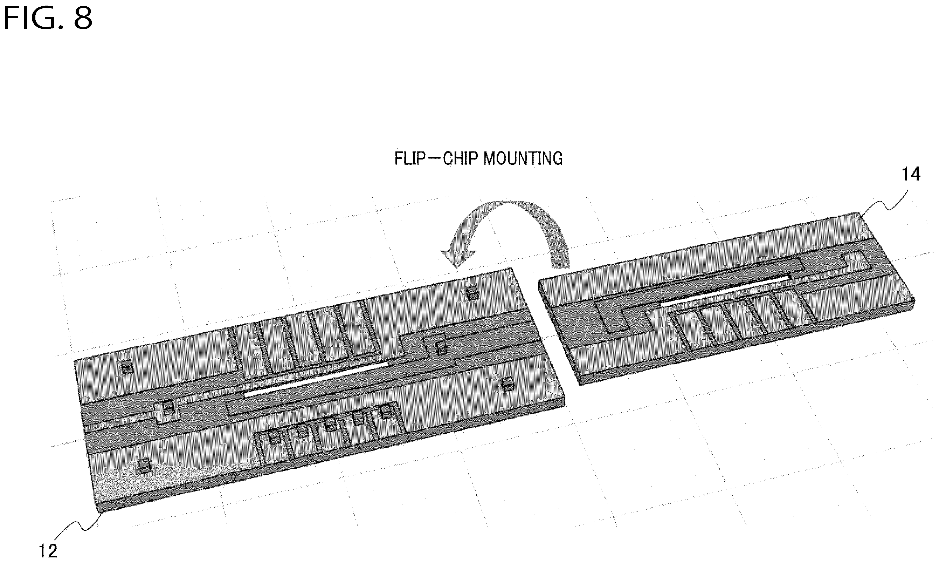

Figure 8 shows a schematic diagram of flip-chip mounting by inverting the upper chip 14 and overlapping it on top of the lower chip 12.

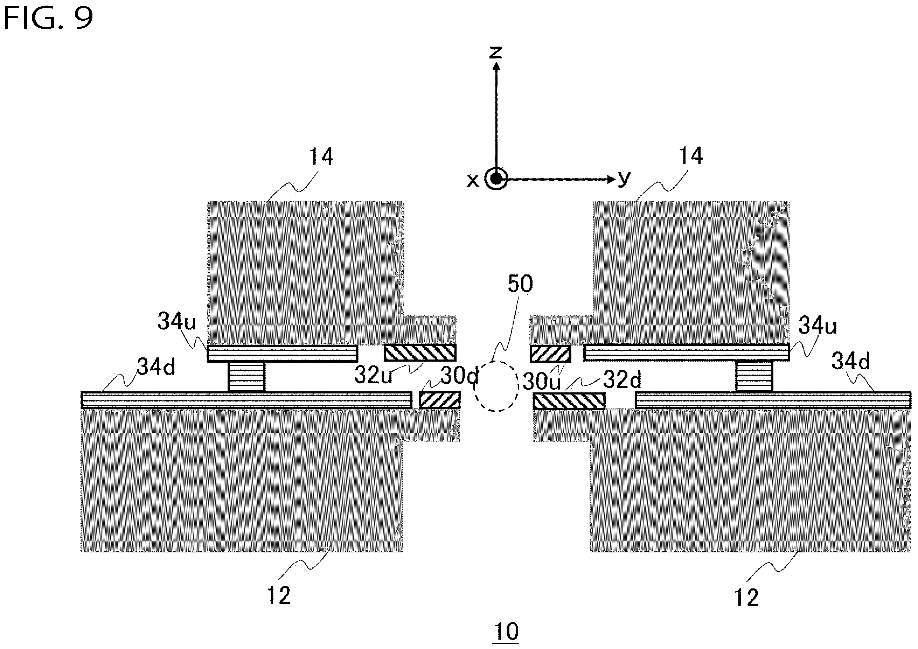

Figure 9 is a cross-sectional view of the superconducting circuit 10 in the y-z plane including the electron trap region 50. The lower chip 12 comprises a lower cooling electrode 30d, a lower microwave electrode 32d and a lower ground electrode 34. The upper chip 14 comprises an upper microwave electrode 32u at a position opposite the lower cooling electrode 30d and an upper cooling electrode 30u at a position opposite the lower microwave electrode 32d. In this way, the electron trap region 50 is configured in the region surrounded by the four electrodes, namely, lower cooling electrode 30d, lower microwave electrode 32d, upper cooling electrode 30u and upper microwave electrode 32u.

By configuring the electron trap device 1 as described above, electrons can be cooled and trapped in the electron trap region 50. Furthermore, the microwave output required to trap electrons can be reduced to about 10pW when the microwave frequency is 6GHz, on the other hand, the room temperature electron trap described in Non-Patent Literature 1, for example, requires a very high output such as several watts.

### The second embodiment

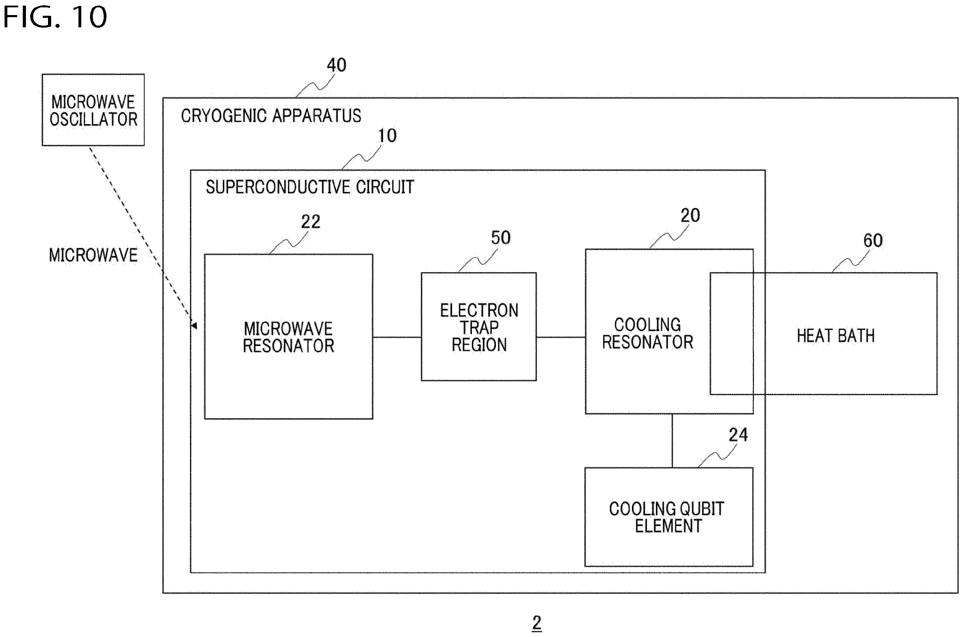

Figure 10 shows a functional block diagram of the electron trap device 2 according to the second embodiment. The electron trap device 2 comprises a cryogenic apparatus 40, a superconducting circuit 10 and a heat bath 60. The superconducting circuit 10 and the heat bath 60 are placed in the cryogenic apparatus 40. This allows the superconducting circuit 10 to operate at a low temperature. The heat bath 60 is maintained at a constant low temperature, for example, about 20mK. The superconducting circuit 10 comprises a cooling resonator 20, a microwave resonator 22, an electron trap region 50 and a cooling qubit element 24. The superconducting circuit 10 comprises a flip-chip structure such that the electron trap region 50 comprises a plurality of opposing electrodes. In other words, the electron trap device 2 differs from the electron trap device 1 of Fig. 1 in that it further comprises a cooling qubit element 24. The other configurations of the electron trap device 2 are the same as those of the electron trap device 1.

The cooling qubit element 24 is fabricated using a Josephson junction, for example. The cooling qubit element 24 raises the oscillation frequency of the electrons to a frequency at which the heat bath 60 can be regarded as substantially a vacuum. The trapped electrons make electrical contact with the heat bath after their oscillation frequency has been converted using the cooling qubit element, i.e., raised to a frequency high enough that the heat bath can be regarded as a substantially vacuum.

According to this embodiment, the cooling effect is greatly improved because it prevents heat from flowing into the electrons from the heat bath 60.

### The third embodiment

The electron trap device according to the third embodiment comprises a resonator that converts the vibrational state of the electrons into microwave photons of microwave frequency. In one example, the electron trap device further comprises a microwave photon reader that reads out the characteristics of the converted microwave photons.

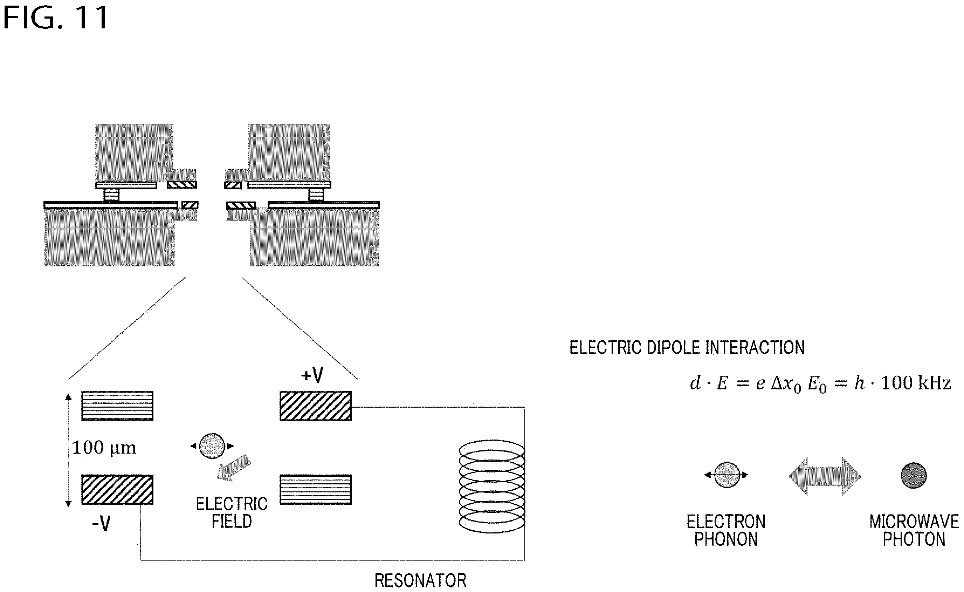

Figure 11 schematically shows the principle of the electron trap device according to the third embodiment. In the four-electrode configuration of Figure 11, for example, we assume that an electric field is applied from the top right to the bottom left as shown in the figure. Electrons oscillating in the electron trap region can be interpreted as electric dipoles, therefore they have an electric dipole interaction with this electric field. The frequency of this interaction can be estimated as 1kHz~100kHz, for example. Here, by providing a resonator to convert the vibrational state of electrons into microwave photons at microwave frequencies, electron oscillations, hereinafter also referred to as "electron phonons", and microwave photons, hereinafter also referred to as "microwave photons", can be converted into each other. Furthermore, a microwave photon reader can be provided to read out the characteristics of such converted microwave photons.

### The fourth embodiment

The electron trap device according to the fourth embodiment comprises a qubit element that excites a qubit based on the vibrational state of electrons.

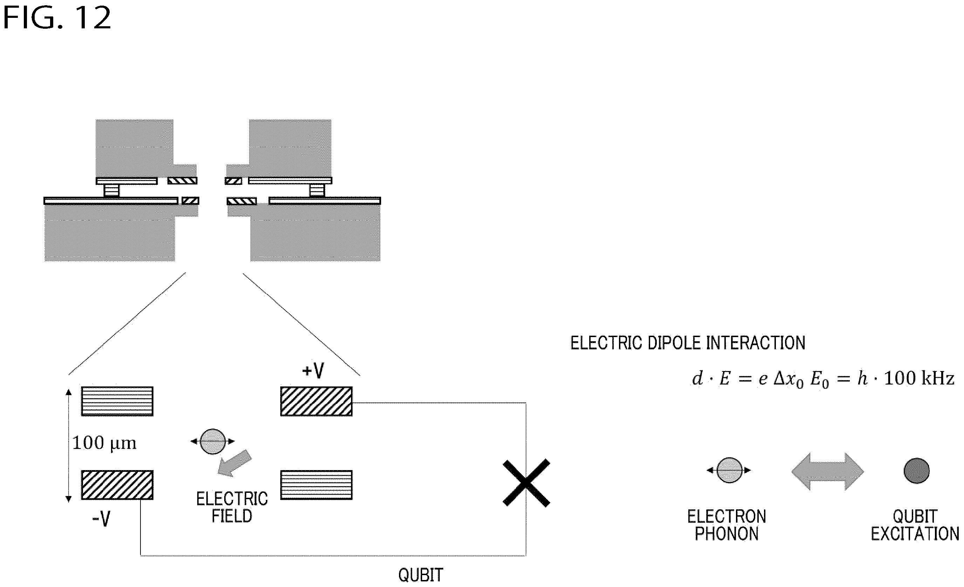

Figure 12 schematically shows the principle of the electron trap device according to the fourth embodiment. Figure 12 shows an example in which the resonator in Figure 11 is replaced with a qubit element. This allows the qubit to be excited based on the vibrational state of the electrons. In other words, the excitation of the electron phonon and the excitation of the qubit can be converted into each other.

### The fifth embodiment

The electron trap device according to the fifth embodiment comprises a magnetic field gradient generator that generates a magnetic field gradient in the electron trap region. In one example, the electron trap device further comprises a spin reader that reads out information on the electron spin observed based on such a magnetic field gradient. In another example, the electron trap device further comprises a quantum entanglement generator that generates quantum entanglement based on the information of electron spins.

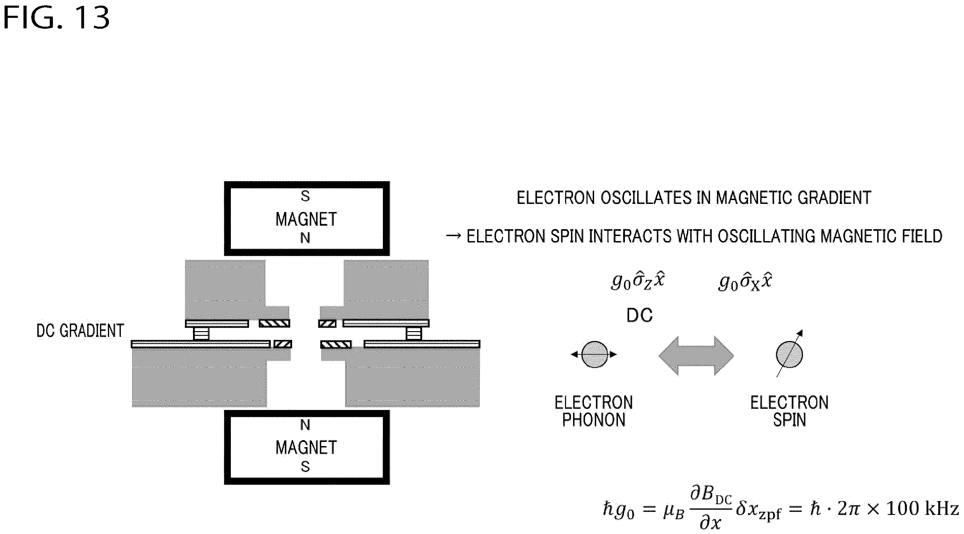

Figure 13 schematically shows the principle of the electron trap device according to the fifth embodiment. In the configuration shown in Figure 13, magnets are placed with their N poles facing each other at the top of the upper chip and at the bottom of the lower chip of the superconducting circuit shown in Figure 9, respectively. This creates a non-uniform magnetic field, i.e., a magnetic field with a magnetic field gradient, in the electron trap region. Electrons have spin, hereinafter referred to as "electron spin". When electrons oscillate in a magnetic field gradient, an interaction occurs between the electron spin and the magnetic field. The force that the electron receives from the magnetic field is proportional to the product of the magnetic moment of the electron spin and the magnetic field gradient. The frequency associated with this electron spin-vibration interaction can be estimated to be about 100kHz, for example. Thus, by providing a magnetic field gradient generator that generates a magnetic field gradient in the electron trap region, energy exchange between electron phonons and electron spins can be realized. Furthermore, a spin reader can be provided to read out information on the observed electron spins based on such a magnetic field gradient. Furthermore, a quantum entanglement generator can be provided to generate quantum entanglement based on such information of electron spins.

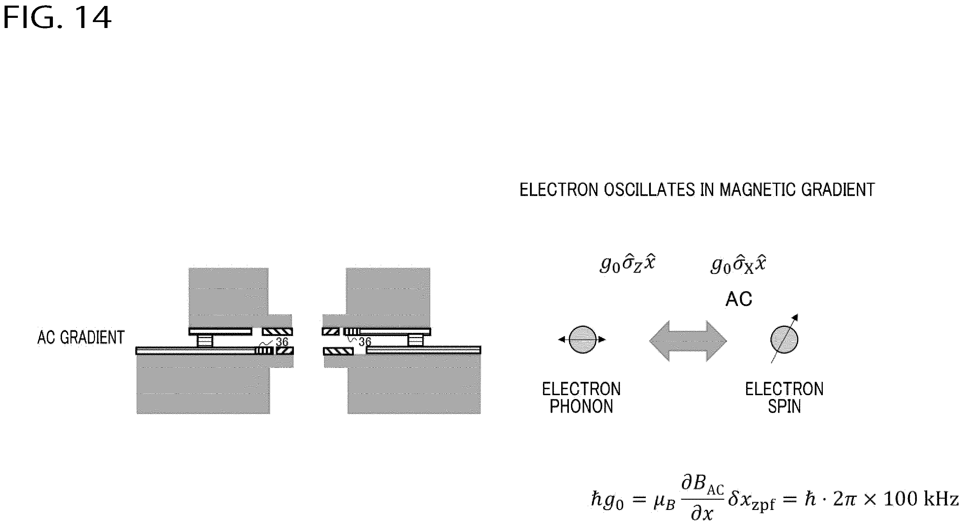

Figure 14 schematically shows another example of the electron trap device according to the fifth embodiment. In the example of Figure 13, the magnetic field gradient formed in the electron trap region was a DC gradient. In contrast, in the example of Figure 14, an AC gradient is formed.

In one embodiment, the electron trap device may comprise a control unit that controls the cooling of the electrons, the excitation of the qubits and the read-out of the properties of the converted microwave photons. This allows the electron trap device to have these functions and operate while switching between them.

### The sixth embodiment

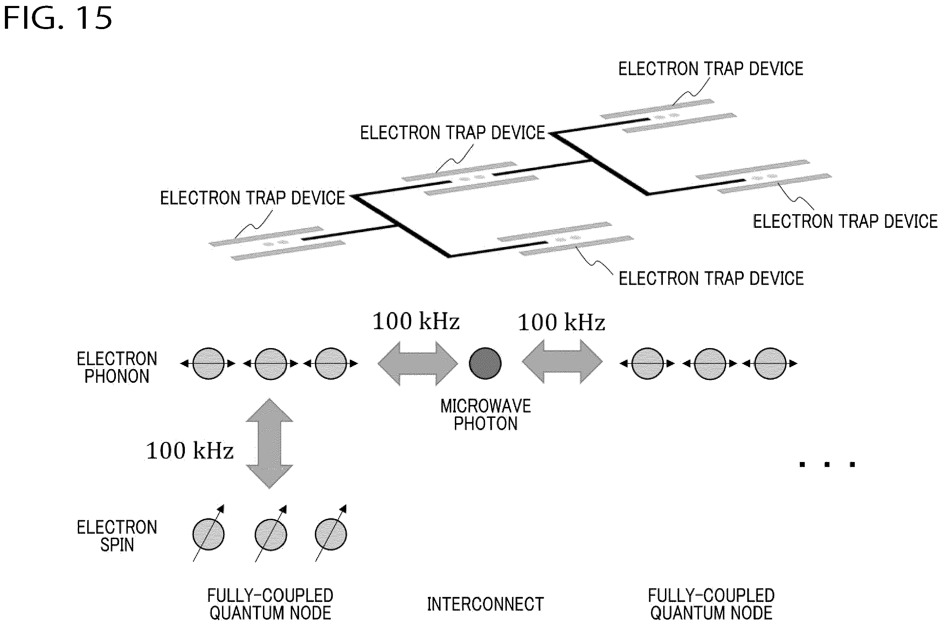

Figure 15 schematically shows a quantum computer according to the sixth embodiment. This quantum computer is composed by connecting the electron trap devices according to the sixth embodiment to each other. The top row of Figure 15 shows a quantum computer with a total of five electron trap devices connected. Each electron trap device traps a plurality of electrons, two electrons each in this example. The electrons in each electron trap oscillate in the same way as each other due to Coulomb interaction. This forms electron phonons. These electron phonons can exchange energy with electron spins using the aforementioned magnetic field gradient. This forms a fully coupled quantum node between the electron phonon and the electron spin. These fully coupled quantum nodes can interconnect with fully coupled quantum nodes in adjacent electron trap regions by converting electron phonons to microwave photons. By interconnecting fully coupled quantum nodes in this way, a networked quantum computer can be realized as a whole. Such interconnections between fully coupled quantum nodes have not yet been realized in ion traps.

### The seventh embodiment

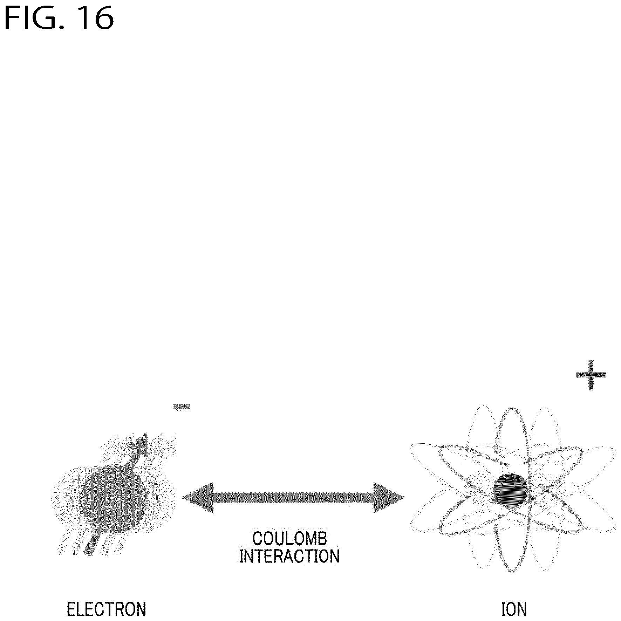

Figure 16 shows a schematic diagram showing a system in which electrons which are trapped by an electron trap device and ions which are trapped by an ion trap device are coupled by Coulomb interaction.

The Coulomb interaction between electrons and ions can be used to cool the electrons to their ground state by interacting the ions with the electrons, which are cooled by an ion cooler, for example, laser cooling. A superconducting cooling resonator is not necessary in this system because laser cooling of ions can be performed at room temperature. The closer the electrons and ions are to each other, the stronger this interaction is. Electrons and ions can be trapped independently using the Paul trap, for example. However, there is a problem to be solved in order to trap electrons and ions simultaneously.

The first issue is that there is a significant difference in mass between electrons and ions. That is, the mass of an ion is about 10⁴ to 10⁵ times greater than that of an electron. Therefore, the frequency of secular motion and the applied voltage for trapping are different between electrons and ions. Therefore, in order to trap electrons and ions a simultaneously, it is necessary to optimally design each electrode.

The second issue is that the positive and negative charges are opposite for electrons and ions. That is, the charge of electrons is negative, and the charge of ions is positive. The effective potential formed by the AC voltage is effective for both electrons and ions. However, a linear Paul trap requires a DC voltage as well. Therefore, a simple end-capped structure cannot form an axial trapping potential to trap electrons and ions simultaneously.

Furthermore, the distance between electrons and ions should be as short as possible. On the other hand, it is important to keep them separated by a certain distance. The purpose of this treatment is to prevent the occurrence of recombination, so that trapping of electrons by ions does not occur.

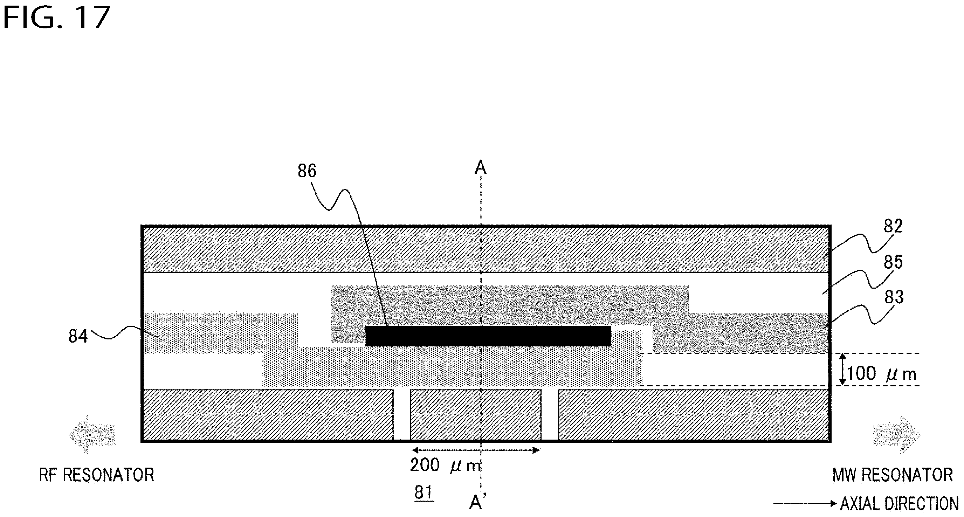

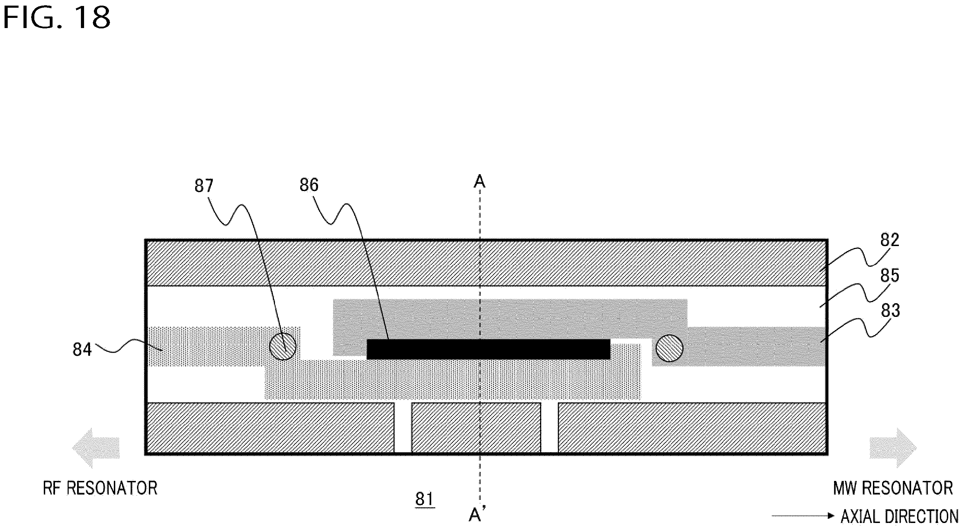

Figure 17 is a top view schematically showing the upper chip 80 to realize the electron-ion simultaneous trap chip according to the seventh embodiment. Figure 18 is a top view schematically showing the lower chip 81 of the electron-ion simultaneous trap chip according to the seventh embodiment. The upper chip 80 and the lower chip 81 comprise DC electrodes 82, a microwave electrode 83 and an RF electrode 84, which are arranged on an insulator 85. The microwave electrode 83 and the RF electrode 84 extend axially between the DC electrodes 82. A through hole 86 is provided between the microwave electrode 83 and the RF electrode 84. Conducting pillars 87 are provided in the microwave electrode 83 and the RF electrode 84.

The microwave electrode 83 is used to trap electrons. The RF electrode 84 is used to trap ions. The electron-ion simultaneous trapping chip is realized by flip-chip mounting the upper chip 80 and the lower chip 81.

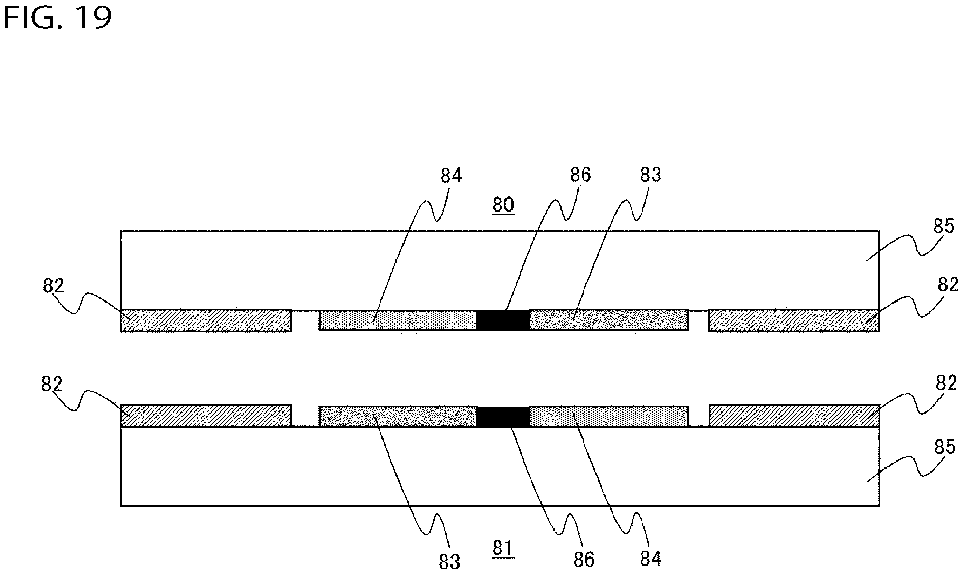

Figure 19 shows a cross-sectional view of the flip-chip mounting of the upper chip 80 and the lower chip 81 in the A-A' cross section of Figures 18 and 19. As illustrated, the DC electrode 82 of the upper chip 80 and the DC electrode 82 of the lower chip 81 face each other. The microwave electrode 83 of the upper chip 80 and the RF electrode 84 of the lower chip 81 face each other. The RF electrode 84 of the upper chip 80 and the microwave electrode 83 of the lower chip 81 face each other.

The following are the results of calculated potential by the electromagnetic field simulator, COMSOL, under the condition that a microwave voltage of 6GHz-10V is applied to the microwave electrode and a RF voltage of 90MHz-20V is applied to the RF electrode for flip-chip mounting of the upper chip 80 and the lower chip 81.

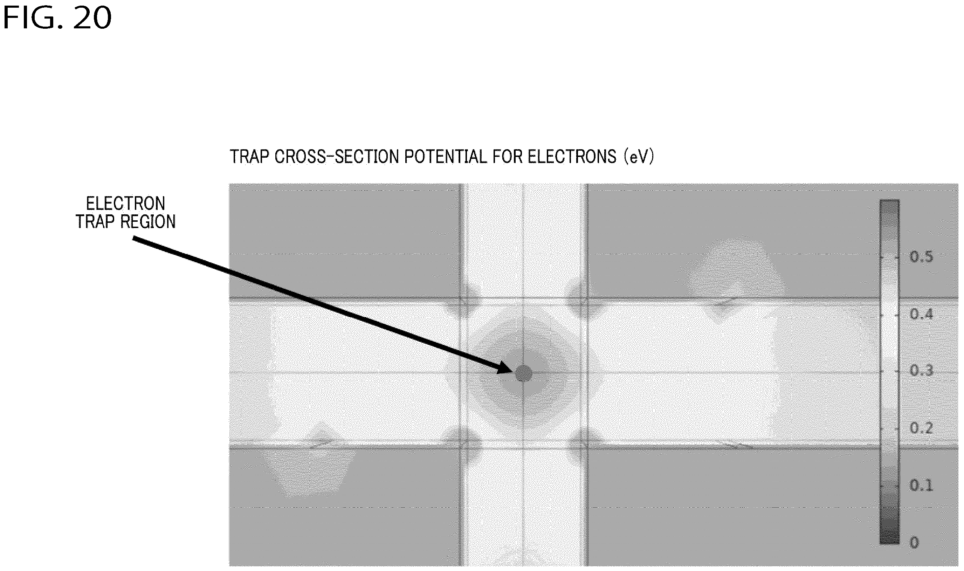

Figure 20 shows the trap cross-section potential for electrons formed under the above condition. As shown in the figure, the potential that realizes the electron trap region is formed in the center, red circle.

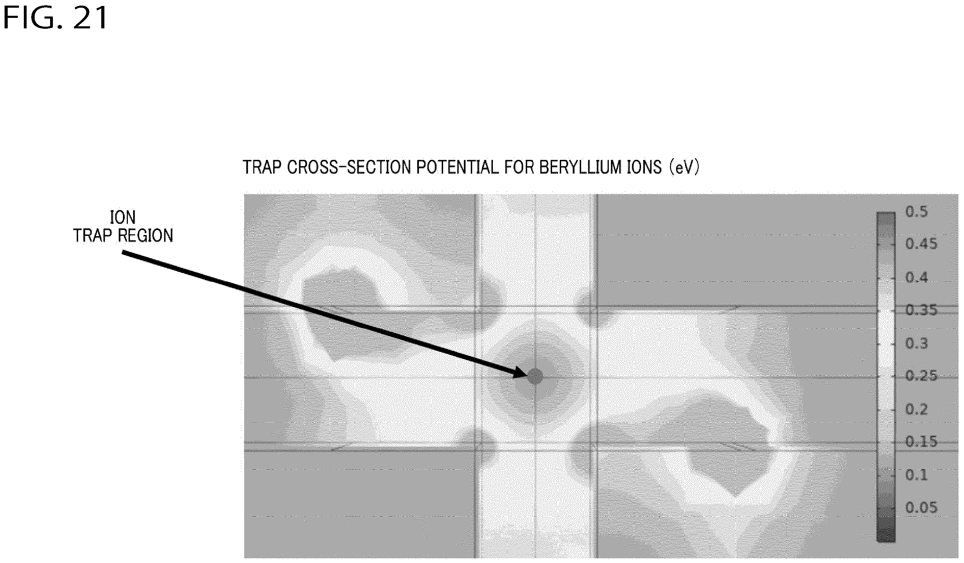

Figure 21 shows the trap cross-section potential for beryllium ions formed under the above condition. As shown in the figure, the potential that realizes the beryllium ion trap region is formed in the center, red circle.

Furthermore, it can be seen that by applying a DC voltage to the DC electrodes, the electrons and ions move in opposite directions. Thus, the distance between electrons and ions can be controlled by the voltage applied to the DC electrodes.

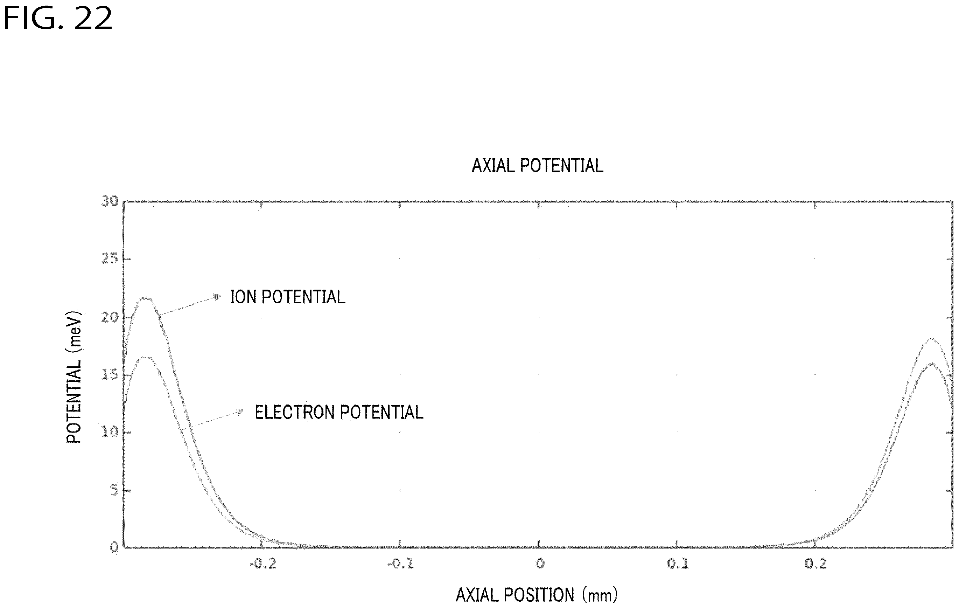

Figure 22 shows the axial potential distribution of electrons and beryllium ions formed by flip-chip mounting the upper chip 80 and the lower chip 81. As illustrated, for each of the electrons and ions, a well-shaped electrostatic potential is formed around the axial position 0. By flip-chip mounting the upper chip 80 and the lower chip 81 in this manner, it is possible to trap electrons and ions simultaneously. These trapped electrons and ions can have a Coulomb interaction with each other.

By applying this flip-chip mounting to the device of the embodiment shown in Figure 6, an electron trap device that can trap electrons and ions simultaneously can be realized.

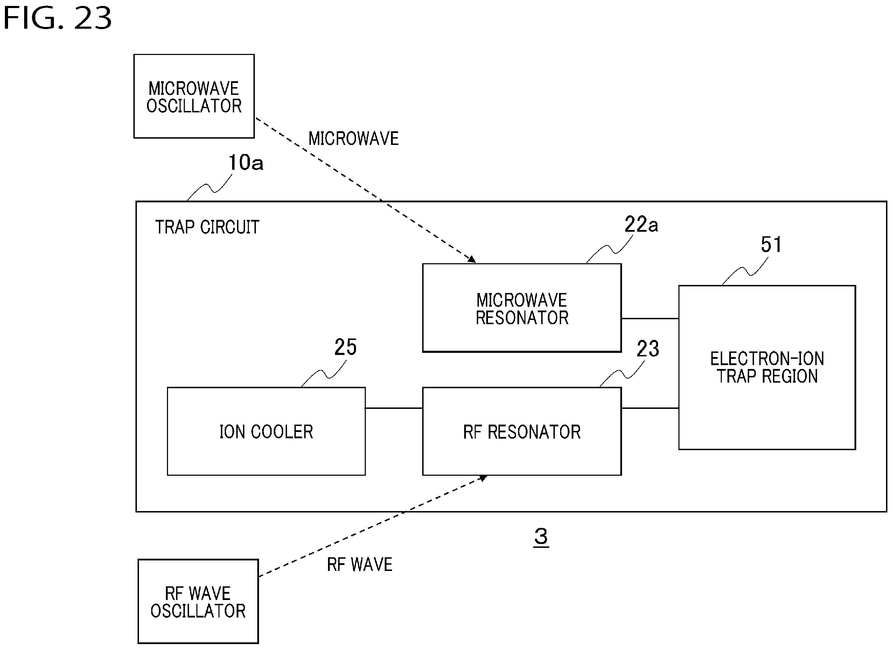

Figure 23 shows a functional block diagram of the electron trap device 3 according to the seventh embodiment. The electron trap device 3 comprises a trap circuit 10a with an ion cooler 25, a microwave resonator 22a, an RF resonator 23 and an electron-ion trap region 51. The upper chip 80 and the lower chip 81 comprise DC electrodes 82, a microwave electrode 83 which traps electrons and an RF electrode 84 which traps ions. The microwave electrode 83 and the RF electrode 84 of the upper chip 80 and lower chip 81 extend axially between the DC electrodes 82. The flip structure of the upper chip 80 and the lower chip 81 allows the DC electrode 82 of the upper chip 80 and the DC electrode 82 of the lower chip 81 to face each other, the microwave electrode 83 of the upper chip 80 and the RF electrode 84 of the lower chip 81 to face each other, the RF electrode 84 of the upper chip 80 and the microwave electrode 83 of the lower chip 81 to face each other. This electron trap device 3 allows electrons and ions to be trapped simultaneously. Furthermore, these trapped electrons and ions can have a coulomb interaction with each other.

As described above, in addition to being able to trap electrons and ions simultaneously and cool electrons to the ground state via Coulomb interaction between them, it is possible to creating quantum entanglement between the vibrational states of electrons and ions, as the same effect. Furthermore, through the entangled vibrational states, hybrid quantum systems consisting of electrons and ions can be realized.

### The eighth embodiment

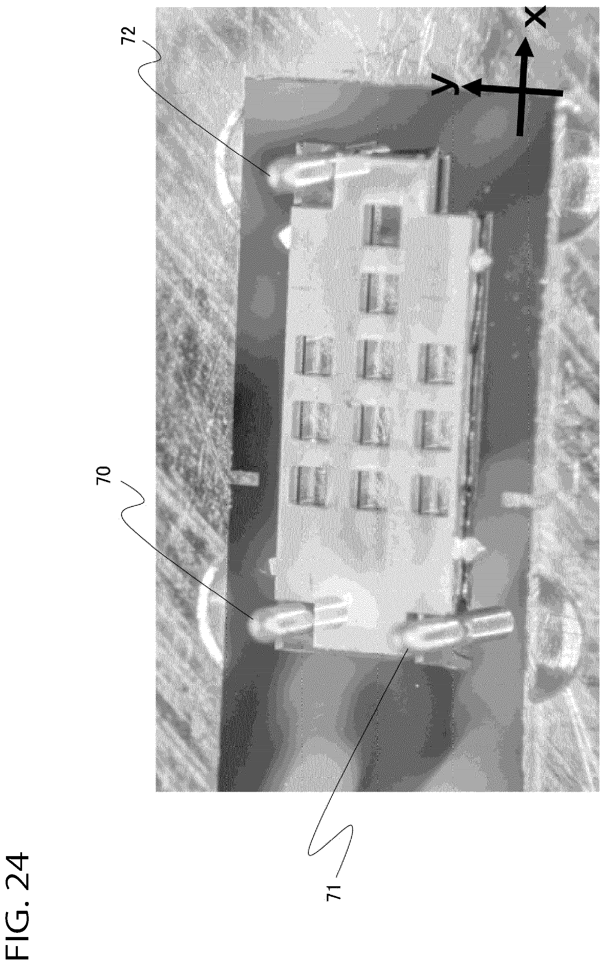

Next, a preferred manufacturing method of the flip-chip structure of the aforementioned electron trap device will be described. Figure 24 is a photograph showing an alignment method for flip-chip mounting of the lower chip 12 and upper chip 14 of Figure 8. Figure 24 shows three alignment pins 70, 71, and 72 for alignment. Alignment in the x-direction is performed using alignment pins 70 and 71, and alignment in the y-direction is performed using alignment pins 70 and 72.

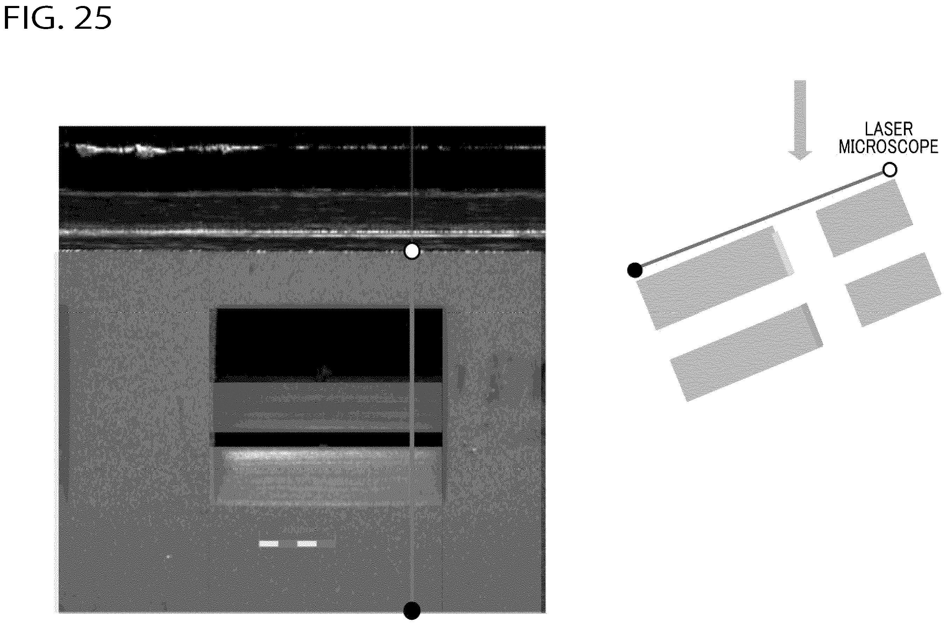

Figure 25 shows the inclination of the upper chip when the upper chip is placed on top of the lower chip without doing anything. In this case, the gap between the upper chip and the lower chip is 145nm, and the inclination angle of the chips is 2.45 degrees.

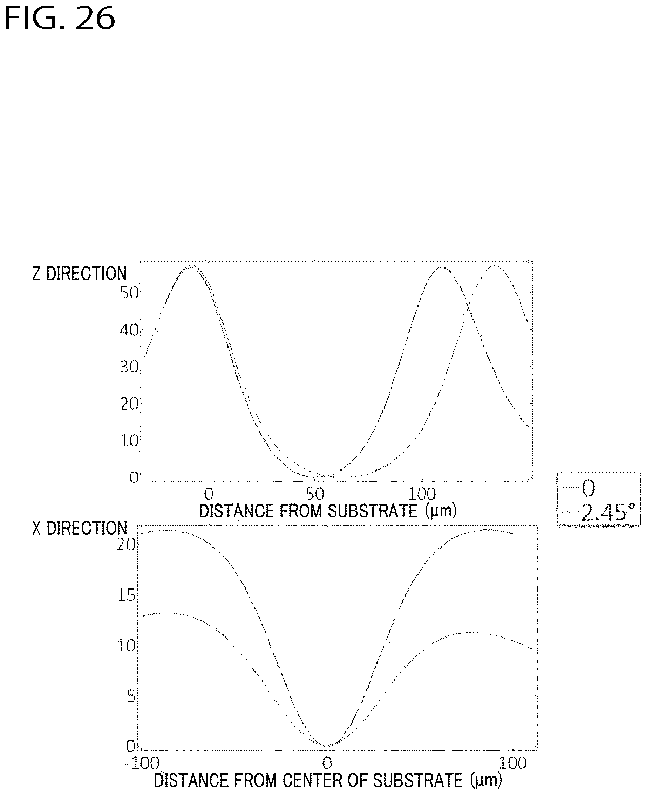

Figure 26 shows the simulation results of the spatial distribution of the effective potential when the inclination of the upper chip is 0 degrees and 2.45 degrees, performed under the assumption that the chip is in contact with the pillar at 600um from the trap point. The upper part of Figure 26 shows the effective potential distribution in the z-direction, i.e., height direction, of the substrate. The lower part of Figure 26 shows the effective potential distribution in the x-direction, i.e., longitudinal direction, of the substrate. As can be seen from these figures, the effect of inclination is small in the z direction, whereas the x direction is larger by about 10meV. This indicates that the angular misalignment must be reduced to improve the effective potential.

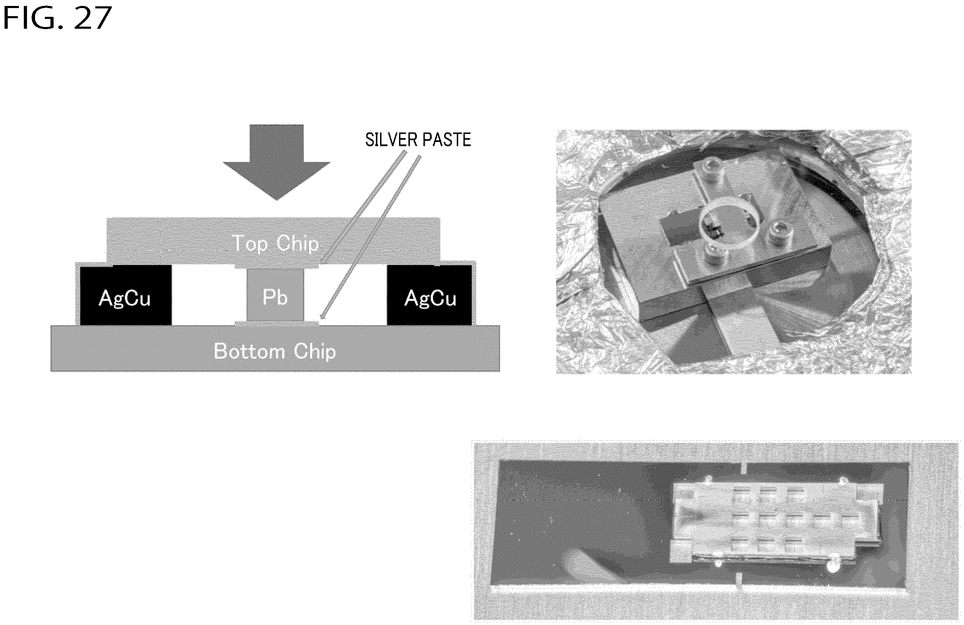

To solve this problem, the inventors found it advantageous to perform flip-chip mounting by the following procedure. That is, first, both ends of the lower chip and the upper chip are supported by a hard metal such as AgCu, and the center part is supported by a soft metal such as Pb. In this state, the upper chip is held from above and heated to bond it to the lower chip. This deforms the soft metal and aligns the height of the upper chip and the lower chip to the height of the hard metal. The hard metal is then coated with silver paste for thermal contact and fixation. Figure 27 shows a flip-chip mounting made with this method.

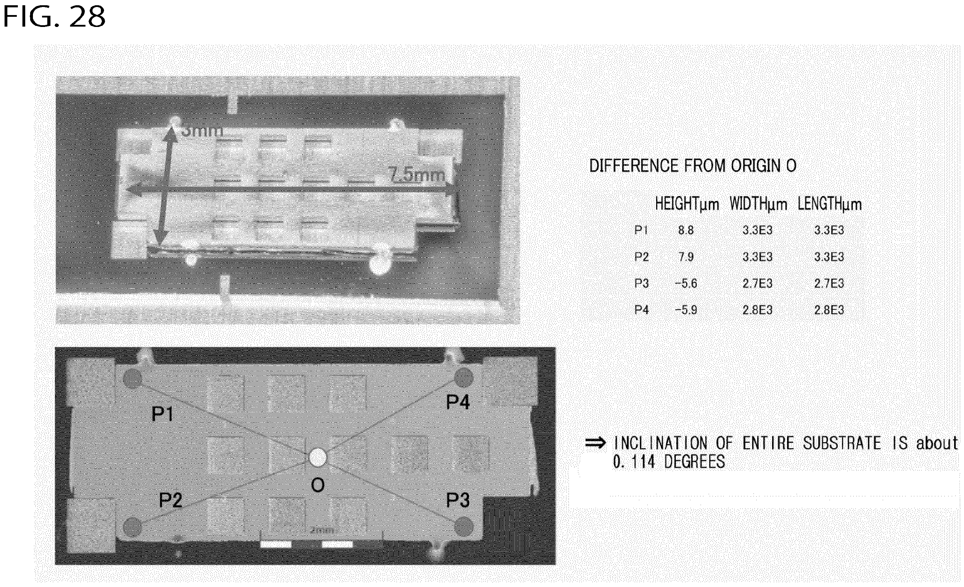

Figure 28 shows the difference, with respect to height, width and length, from the origin at four points P1, P2, P3, and P4 on the chip in Figure 27 created by the above method. The inclination of the entire substrate is thus calculated to be about 0.114 degrees. In other words, according to this method, the inclination of the upper chip is greatly reduced compared to the 2.45 degree inclination of the upper chip when the upper chip is placed on top of the lower chip without doing anything.

The above hard metal should be a metal that does not become superconducting even at low temperature. Such a metal may be, for example, solid Cu or Pt as well as AgCu. On the other hand, the above soft metal may be any metal that becomes superconducting at low temperature. Such a metal may be, for example, In as well as Pb.

### The ninth embodiment

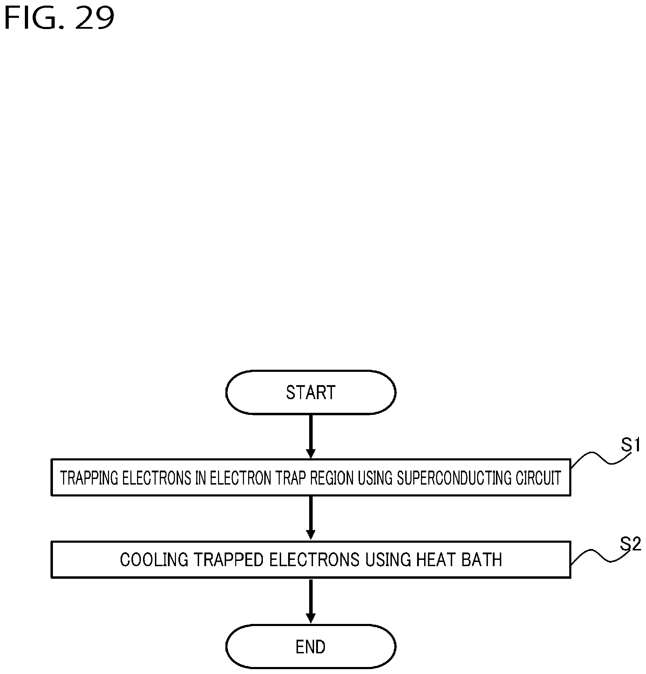

Figure 29 is a flowchart showing the processing of the electron trap method according to the ninth embodiment. The method includes the step S1 of trapping electrons in an electron trap region using a superconducting circuit comprising a cooling resonator, a microwave resonator and an electron trap region, and the step S2 of cooling the trapped electrons using a heat bath. The superconducting circuit comprises a microstructure surrounded by a superconductor, wherein the opposing electrodes are arranged in a position lineally symmetrical to a center line passing through the electron trap region, such that the electron trap region comprises a plurality of opposing electrodes.

According to this method, electrons which are cooled to the ground state can be captured as isolated particles, levitating in space.

The disclosure has been described above based on the embodiments. It is understood by those skilled in the art that these embodiments are examples, that various variations are possible in the combination of their respective components and respective processing processes and that such variations are also within the scope of the invention.

For example, the low-temperature electrons trapped using the electron trap device described in the embodiment can be interpreted as an extremely low-noise electron source. These electrons can be used, for example, to obtain an extremely well-directed electron beam. It is expected that high-performance electron microscopes can be realized by such a beam, for example.

Any combination of the above mentioned embodiments and variants is also useful as an embodiment of the invention. The new embodiment resulting from the combination will have the respective effects of each of the embodiments and variants combined.

### Industrial Applicability.

The above is a description of the embodiments and variations. In understanding the technical ideas abstracted from the embodiments and variations, the technical ideas should not be interpreted as limited to the contents of the embodiments and variations. The aforementioned embodiments and variations are merely concrete examples, and many design changes, such as changes, additions, and deletions of components, are possible. In the embodiments, the contents where such design changes are possible are emphasized with the notation "embodiments". However, design changes are also permitted for contents without such notation.

### INDUSTRIAL APPLICABILITY

The present invention is applicable to electron trap devices, quantum computers, flip-chip structure manufacturing methods and electron trap methods.

This application claims priority based on U.S. Provisional Patent Application No. 63246977, filed September 22, 2021. The entire specification of the provisional application is incorporated herein by reference.

### REFERENCE SIGNS LIST

1 Electron trap device
2 Electron trap device
3 Electron trap device
10 Superconductive circuit
10a Superconducting circuit
12 Upper chip
14 Lower chip
20 Cooling resonator
22. Microwave resonator
22a Microwave resonator
23 RF resonator
24 Cooling qubit element
25 Ion cooler
30d Lower cooling electrode
32d Lower microwave electrode
34d Lower ground electrode
30u Upper cooling electrode
32u Upper microwave electrode
34u Upper ground electrode
36 Superconductive wiring
40 Cryogenic apparatus
50 Electron trap region
51 Electron-ion trap region
60 Heat bath
71 Alignment pin
72 Alignment pin
73 Alignment pin
80 Upper chip
81 Lower chip
82 DC electrode
83 Microwave electrode
84 RF electrode
85 Insulator
86 Through hole
87 Conducting pillar
O Origin on the chip
P1 A point on the chip
P2 A point on the chip
P3 A point on the chip
P4 A point on the chip
S1 The step of trapping electrons in the electron trap region using a superconducting circuit
S2 The step of cooling the trapped electrons using a heat bath

## Claims

1. An electron trap device for trapping electrons, comprising:
a superconducting circuit comprising a cooling resonator, a microwave resonator and an electron trap region;
a cryogenic apparatus for operating the superconducting circuit; and
a heat bath for cooling the electrons,
wherein the superconducting circuit comprises a microstructure in which opposing electrodes are arranged in a position that is linear symmetrical to the center line through the electron trap region and surrounded by a superconductor, such that the electron trap region comprises a plurality of opposing electrodes.

2. The electron trap device according to claim 1,
wherein the microstructure has a length of 1mm or less per side.

3. The electron trap device according to claim 1 or 2,
wherein the microstructure is a flip-chip structure.

4. The electron trap device according to any one of claims 1 to 3,
wherein the electron trap region comprises at least two cooling electrodes and at least two microwave electrodes.

5. The electron trap device according to any one of claims 1 to 4,
wherein the superconducting circuit comprises a circuit comprising a Josephson element for raising the oscillation frequency of the electrons before bringing them into contact with the heat bath.

6. The electron trap device according to claim 5,
wherein the circuit comprising a Josephson element is a cooling qubit element.

7. The electron trap device according to any one of claims 1 to 6, comprising a resonator that converts the vibrational state of the electrons into microwave photons of microwave frequency.

8. The electron trap device according to claim 7, comprising a microwave photon reader that reads out the characteristics of the converted microwave photons.

9. The electron trap device according to any one of claims 1 to 8, comprising a qubit element for exciting a qubit based on the vibrational state of the electrons.

10. The electron trap device according to any one of claims 1 to 9, comprising a magnetic field gradient generator that generates a magnetic field gradient in the electron trap region.

11. The electron trap device according to claim 10, comprising a spin reader that reads out information on the electron spin observed based on such a magnetic field gradient.

12. The electron trap device according to claim 11, comprising a quantum entanglement generator that generates quantum entanglement based on the information of electron spins.

13. The electron trap device according to any one of claims 7 to 12, comprising a control unit that controls the cooling of the electrons, the excitation of the qubits and the read-out of the properties of the converted microwave photons.

14. A quantum computer comprising electron trap devices according to claim 12 connected together.

15. A method for manufacturing a flip-chip structure of an electron trap device according to any one of claims 3 to 13, including:
supporting both ends of the lower chip and the upper chip by a metal that does not become superconducting even at low temperature and supporting the center part by a metal that becomes superconducting at low temperature;
holding the upper chip from above in the state and bonding it to the lower chip; and
coating the metal that does not become superconducting with silver paste for thermal contact and fixation.

16. The method according to claim 15,
wherein the metal that does not become superconducting is harder than the metal that becomes superconducting.

17. The method according to claim 15 or 16,
wherein the metal that does not become superconducting is AgCu, Cu or Pt and
wherein the metal that becomes superconducting is Pb or In.

18. An electron trapping method for trapping electrons, including:
trapping electrons in an electron trap region using a superconducting circuit comprising a cooling resonator, a microwave resonator, and the electron trap region; and
cooling the trapped electrons using a heat bath,
wherein the superconducting circuit comprises a microstructure in which the opposing electrodes are arranged in a position that is linear symmetrical to the center line through the electron trap region and surrounded by a superconductor, such that the electron trap region comprises a plurality of opposing electrodes.

19. An electron trap device that simultaneously traps electrons and ions and cools the electrons to their ground state through Coulomb interaction between the electrons and ions, comprising:
a trap circuit comprising an ion cooler, a microwave resonator, an electron trap region, and an ion trap region,
wherein the trap circuit comprises an upper chip and a lower chip,
wherein each of the upper chip and the lower chip comprises a DC electrode, a microwave electrode for trapping electrons and an RF electrode for trapping ions,
wherein the microwave electrode and the RF electrode of the upper chip and the lower chip extend axially between the DC electrodes and
wherein the flip structure of the upper chip and the lower chip allows the DC electrode of the upper chip and the DC electrode of the lower chip to face each other, the microwave electrode of the upper chip and the RF electrode of the lower chip to face each other, the RF electrode of the upper chip and the microwave electrode of the lower chip to face each other.
